Europäisches Patentamt

European Patent Office

Office européen des brevets

(19)

(11) Veröffentlichungsnummer : **0 291 444 B1**

## (12) EUROPÄISCHE PATENTSCHRIFT

(45) Veröffentlichungstag der Patentschrift :
**12.08.92 Patentblatt 92/33**

(51) Int. Cl.$^5$ : **C23C 16/18, C04B 41/49**

(21) Anmeldenummer : **88730112.5**

(22) Anmeldetag : **10.05.88**

(54) Herstellung von Polymer-Metallverbindungen durch Abscheidung in Glimmentladungszonen.

(30) Priorität : **12.05.87 DE 3716235**

(43) Veröffentlichungstag der Anmeldung :
**17.11.88 Patentblatt 88/46**

(45) Bekanntmachung des Hinweises auf die
Patenterteilung :
**12.08.92 Patentblatt 92/33**

(84) Benannte Vertragsstaaten :
**BE CH DE ES FR GB IT LI LU NL SE**

(56) Entgegenhaltungen :
**EP-A- 0 027 625
EP-A- 0 195 223
JOURNAL OF VACUUM SCIENCE & TECHNO-
LOGY A, Band 3, Nr. 6, November-Dezember
1985, Seiten 2098-2101, New York, US; N.MO-
ROSOFF et al.: "Transition metal containing
plasma polymers"**

(56) Entgegenhaltungen :
**JOURNAL OF VACUUM SCIENCE & TECHNO-
LOGY A, Band 3, Nr. 6, November-Dezember
1985, Seiten 2093-2097, American VacuumSociety, New York, US; R.K. SADHIR et al.:
"Deposition of conducting thin films of organometallic monomers by plasmapolymerization"
Römpps Chemie Lexikon; 8. Auflage,
Franckh'sche Verlagshandlung, Stuttgart,
1985, Seiten 2559-2562 (Stichwort:"Metallorganische Verbindungen")**

(73) Patentinhaber : **SCHERING
AKTIENGESELLSCHAFT Berlin und
Bergkamen
Müllerstrasse 170/178 Postfach 65 03 11
W-1000 Berlin 65 (DE)**

(72) Erfinder : **Suhr, Harald, Prof. Dr. rer. nat.
Weissdornweg 2
W-7400 Tübingen (DE)**
Erfinder : **Etspüler, Angelika, Dipl.-Chem.
Philosophenweg 79
W-7400 Tübingen (DE)**
Erfinder : **Feurer, Ernst, Dipl.-Chem.
Eichendorff-Strasse 15
W-7400 Tübingen-Hirschau (DE)**
Erfinder : **Oehr, Christian, Dipl.-Chem.
Wintergasse 6
W-7403 Reusten (DE)**

EP 0 291 444 B1

Jouve, 18, rue Saint-Denis, 75001 PARIS

## Beschreibung

Die Erfindung betrifft ein Verfahren zur Herstellung von Polymer-Metallverbindungen, bei denen die elektrische Leitfähigkeit in groben Grenzen variiert und auf gewünschte Werte eingestellt werden kann.

Es sind bereits Verfahren bekannt, mit denen flüchtige metallorganische Verbindungen in einer Glimmentladungszone zersetzt und zu Verbindungen polymerisiert werden, die Metall-Bestandteile enthalten. Man bezeichnet dies auch als Plasmapolymerisation.

So beschreiben Sadhir und Saunders (J. Vac. Sci. Technol. A3 (6), 2093 (1985)) die Plasmapolymerisation von Tetramethylzinn, Tetrahylzinn und anderen Verbindungen. Hierbei werden entweder keine zusätzlichen organischen Monomere oder aber nur fluorierte Kohlenwasserstoffe, die zum Ätzen des Substrates dienen, in die Reaktionszone eingebracht. Man erhält vorwiegend Filme mit extrem hohen Widerstandswerten oder reine Nichtleiter. Soweit leitfähige Filme erzeugt werden, ist der Wert der Leitfähigkeit von der Geometrie der Versuchsanordnung, insbesondere vom bestand der Zuführung des metallorganischen Monomers Zum Substrat abhängig. Es ist verständlich, daß auf diese Weise keine Polymer-Metallfilme mit einem vorbestimmten, gewünschten Widerstandswert erhalten werden.

Perrin et al.(J. Vac. Sci. Technol. A4(1), 46 (1986)) beschreiben einen Weg zur Herstellung von leitfähigen Metall-/Fluorocarbon-Polymerfilmen. Hierbei wird aber nicht von einer metallorganischen Verbindungen ausgegangen, das für die Plasmapolymerisation erforderliche Metall wird vielmehr durch Kathodenzerstäubung erzeugt (zum Beispiel an der Gegenelektrode der Glimmentladungszone). Mit diesem Verfahren erhält man einen rein organischen Polymerfilm, in den die Metallpartikel in Form zahleicher kleiner, voneinander getrennter Inseln eingebettet sind. Typische Eigenschaften solcher Filme sind Grenzwerte der "Inseldichte" und Sprünge der elektrischen Leitfähigkeit, wenn der Metallgehalt des Films etwa 50 Atomprozente erreicht. Es ist deshalb praktisch nicht möglich, Filme mit elektrischen Leitfähigkeiten gezielt über einen Bereich zu erhalten.

Untersuchungen von Morosoff und Haque (J.Vac. Sci. Technol. A3(6), 2098 (1985)) über die Plasmapolymerisation von Kohlenwasserstoffen mit organischen Verbindungen der Übergangsmetalle haben zum Ziel, den Chemismus der Filmbildung aufzuklären und zu erkennen, welche Endprodukte entstehen. Es wurden keien Leitfähigkeitsmessungen durchgeführt, es ist den Ergebnissen nicht zu entnehmen, ob überhaupt leitfähige Filme oder nur nichtleitende Filme erhalten wurden.

Verfahren zur Herstellung metallischer Strukturen, jedoch von harten, widerstandsfähigen Polymerfilmen mit hohen Isolationswerten, werden in der EP-A3-0 195 223 beschrieben. Gegenstand dieser Lehre sind jedoch keine leitenden Filme und Verfahren mit der Möglichkeit der Variation und Einstellung der Leitfähigkeit.

Aufgabe der vorliegenden Erfindung ist es, Polymer-Metallverbindungen durch Abscheidung in Glimmentladungszonen herzustellen, sodaß unter festgelegten Arbeitsbedingungen auf ein Substrat ein Polymer-Metallfilm mit bestimmten elektrischen Eigenschaften erzeugt werden kann.

Diese Aufgabe wird durch ein Verfahren gemäß dem kennzeichnenden Teil des Patentanspruchs 1 gelöst. Vorteilhafte Weiterbildungen der Erfindung sind in den Unteransprüchen beschrieben.

Die Erindung ermöglicht es insbesondere, mit Hilfe von Masken Widerstände auf anorganischen oder organischen Nichtleitern herzustellen und diese Widerstände in elektronische Schaltkreise zu integrieren. Mit ihr lassen sich auch leitfähige Schichten zur Ableitung von statischer Elektrizität und zur beschirmung empfindlicher Schaltungen gegen Störstrahlungen erzeugen. Schließlich kann sie auch zur Beschichtung von Folien, Platten, Scheiben und grobflächigen Substraten eingesetzt werden.

Die nach dem erfindungsgemäßen Verfahren erhaltenen Polymer-Hetallfilme besitzen völlig andere Eigenschaften als Filme, die auf bisher bekannte Weise hergestellt wurden. So ist es insbesondere möglich, über einen Bereich von vielen Zehnerpotenzen elektrische Leitfähigkeiten zu erzeugen, die eine nahezu lineare Abhängigkeit von der Filmzusammensetzung besitzen. Han ist also in der Lage, bestimmte Leitfähigkeiten einfach durch eine exakte Dosierung der flüchtigen metallorganischen Verbindung und der organischen monomeren Verbindung zur Glimmentladungszone zu erzielen. Die Dosierung läßt sich noch verfeinern, wenn, was besonders vorteilhaft ist, zusätzlich ein inertes Trägergas (zum Beispiel Argon) verwendet wird.

Diese besonderen Vorzüge des erfindungsgemäßen Verfahrens basieren auf dem Hechanismus der Filmbindung.

Im Gegensatz zu den bekannten Verfahren wird das metalltragende organische Molekül zunächst auf der Substratoberfläche absorbiert und erst dann durch Wechselwirkung mit dem Plasma und seinem Ionen-, Elektronen- und Photonenbombardement in das Metall überführt. Dabei wird durch das Plasma sowohl das Substrat angeätzt als auch die metallorganische Verbindung - abhängig von der Intensität und Dauer der Einwirkung - in mehr oder weniger metallische Fragmente zerlegt. Wenn die organische Komponente dabei nur unvollständig entfernt wird, entstehen Filme durch Kombination von organischen und metallorganischen Fragmenten. Wenn organische Monomere hinzukommen, werden sie in polymerer Form ebenfalls in den entstehenden Film eingebaut. Dieser Mechanismus hat zur Folge, daß der gebildete Film das Metall nicht als Kristalle oder Inseln enthält.

Diese Tatsache, verbunden mit der einfachen Steuerung der Filmeigenschaften durch Einstellung bestimmter Arbeitsparameter, ermöglicht eine "maßgeschneiderte" Herstellung von Widerständen, zum Beispiel für Sensoren, integrierte Schaltungen und andere Anwendungsgebiete.

Von besonderem Vorteil ist noch, daß das Substrat bei Anwendung des erfindungsgemäßen Verfahrens außerordentlich geschont und mit nur geringen Energiedichten belastet wird. Dadurch können auch empfindliche Kunststoffe mit Filmen beschichtet werden, die zum Beispiel bei Kathodenzerstäubung stark geschädigt würden.

Zur Durchführung der Erfindung können normale Plasmareaktoren benutzt werden, die hauptsächlich als Rohr- beziehungsweise Tunnelreaktoren oder als Parallelplatten-Reaktoren bekannt sind. Das Plasma kann sowohl mit Gleichstrom als auch mit Wechselstrom oder hochfrequentem Strom erzeugt werden. Der Druck in der Plasmakammer beträgt im allgemeinen 5 - 100 Pa, es wird also - dies ist ein erheblicher Vorteil gegenüber der Kathodenzerstäubung oder des Bedampfens - kein Hochvakuum mit Drücken von weniger als 3 Pa benötigt, die entsprechende Anforderungen an die Vakuumanlage stellen. Als Substrate, auf denen die Polymer-Metallverbindungen abgeschieden werden können, kommen in erster Linie alle üblichen anorganischen oder organischen Nichtleiter in Frage, insbesondere Aluminiumoxidkeramiken, Siliciumoxidkeramiken, Glas, Metalle mit Oxid- oder Nitritschichten oder Kunststoffe. Sie können als Festmaterialien oder als Folien vorliegen.

Als metallorganische Verbindungen zur Herstellung von Polymerschichten mit bestimmten Leitfähigkeiten sind Allylcyclopentadienylpalladium-(II), Dimethylgold-(III)-acetylacetonat, Zinntetramethyl oder Dicobaltoctacarbonyl geeignet, da diese unter den angewandten Vakuumbedingungen flüchtig beziehunsgweise sublimierbar sind. Die Einspeisung in die Glimmentladungszone erfolgt nach Herstellung des Vakuums zusammen mit Acrylnitril, Propen oder Butan und gegebenenfalls eines Trägergases, so daß im eigentlichen Reaktionsbereich eine gleichmäßige Gasmischung vorliegt. Die Vorratsbehälter für die Metallverbindung und - falls erforderlich - für die o.g. organische monomere Verbindung werden zweckmäßigerweise mit einer Heizvorrichtung versehen.

Als metallorganische Verbindungen sind mit Vorteil geeignet:

Dimethylgold(III)-acetylacetonat
Allylcyclopentadienylpalladium (II)
Zinntetramethyl
Dicobaltoctacarbonyl

Als organische monomere Verbindungen kommen in erster Linie ungesättigte Kohlenwasserstoffe in Frage, doch sind auch gesättigte Verbindungen einsetzbar, da sie unter der Wirkung einer Glimmentladungszone ebenfalls Polymerisationsreaktionen eingehen. So können mit Vorteil Propen, Acrylnitril und Butan verwendet werden.

Als Trägergase sind inerte Gase wie Argon oder Helium, reduzierende Gase wie Wasserstoff, oder deren Gemische geeignet.

Folgende Beispiele, bei denen ein Parallelplattenreaktor benutzt wurde, erläutern die Erfindung:

## BEISPIEL 1

| | |
|---|---|
| Substrat | - Aluminiumoxidkeramik |
| Metallorganische Veränderung | - Allylcyclopentadienylpalladium (II) |
| Organische monomere Verbindung | - Propen |
| Trägergas | - Argon |
| Elektrodentemperatur | - 30° C |
| Heizung des Vorratsbehälters | - entfällt |
| Frequenz | - Gleichspannung 400 V |
| Leistungsdichte | - 0,1 Watt/cm$^2$ |
| Druck im Reaktor | - 20 Pa |
| Reaktionsdauer | - 100 min für 0,5 $\mu$m Filmdicke. |

Unter den angegebenen Arbeitsbedingungen wurden nacheinander verschiedene Keramikplatten beschichtet, wobei jedesmal das Verhältnis von Propen zu Argon im Gasgemisch geändert wurde. Der Anteil an gasförmiger Palladiumverbindung blieb hierbei konstant, da er durch den Dampfdruck der Verbindung bei obigen Arbeitsbedingungen gegeben ist.

An den abgeschiedenen Polymer-Palladiumschichten wurden anschließend die elektrischen Widerstände nach der Vierpunkt-Methode mit einem Gerät von Kulicke und Soffa, Model 331, gemessen. Es ergaben sich folgende Werte:

TABELLE I

| % Propen in Gasphase | Gasfluß sccm* | Pd im Film Gewichts - % | Widerstand $\mu \Omega.cm$ |
|---|---|---|---|
| 0 | 20 | 75 | $5,8 \cdot 10^4$ |
| 33 | 20 | 71 | $1,6 \cdot 10^7$ |
| 50 | 20 | 59 | $1,1 \cdot 10,^8$ |
| 67 | 20 | 43 | $1,0 \cdot 10^8$ |
| 100 | 20 | 0 | $1,0 \cdot 10^8$ |

* standard-cm . $min^{-1}$

Man erhält also allein durch Änderung des Propengehaltes im Gasgemisch Polymerfilme, deren Widerstände über mehrere Zehnerpotenzen wählbar sind, wie die Tabelle 1 zeigt:

BEISPIEL 2

| | |
|---|---|
| Substrat | - Aluminiumoxidkeramik |
| Metallorganische Verbindung | - Allylcyclopentadienylpalladium(II) |
| Organische monomere Verbindung | - Acrylnitril |
| Trägergas | - Argon |
| Elektrodentemperatur | - $120^0$ C |
| Heizung des Vorratsbehälters | - entfällt |
| Frequenz | - Gleichspannung 400 V |
| Leistungsdichte | - 0,1 Watt/$cm^2$ |
| Druck im Reaktor | - 20 Pa |
| Reaktionsdauer | - 100 min für 0,5 $\mu$m Filmdicke |

Gegenüber Beispiel 1 wurde bei der Herstellung der Polymer-Palladiumverbindung als organische monomere Verbindung Acrylnitril statt Propen eingesetzt und mit einer höheren Elektrodentemperatur gearbeitet. Dadurch konnten Werte für den elektrischen Widerstand erreicht werden, die um zwei Zehnerpotenzen niedriger als im Beispiel 1 lagen:

4

TABELLE II

| % Acrylnitril in Gasphase | Gasfluß sccm | Pd im Film Gewichts-% | Widerstand $\mu\Omega$ . cm |
|---|---|---|---|
| 0 | 100 | 94 | $4,3 . 10^2$ |
| 20 | 100 | 49 | $5,2 . 10^7$ |
| 25 | 100 | 47 | $9,1 . 10^7$ |
| 50 | 100 | 42 | $> 1,0 . 10^8$ |

BEISPIEL 3

| | |
|---|---|
| Substrat | - Polyimid |
| Metallorganische Verbindung | - Dimethylgold(III)-acetylacetonat |
| Organische monomere Verbindung | - Propen |
| Trägergas | - Argon |
| Elektrodentemperatur | - $25^0$ C |
| Heizung des Vorratsbehälters | - $60^0$ C |
| Frequenz | - 13,56 MHz |
| Leistungsdichte | - 0,05 Watt/$cm^2$ |
| Druck im Reaktor | - 25 Pa |
| Reaktionsdauer | - 90 min für 0,5 $\mu$m Filmdicke |

Widerstandsmessungen an den erhaltenen Polymer-Gold-Verbindungen ergaben folgende Werte:

TABELLE III

| % Propen in Gasphase | Gasfluß sccm | Au im Film Gewichts-% | Widerstand $\mu\Omega$ . cm |
|---|---|---|---|
| 0 | 0 | 73 | $2,0 . 10^3$ |
| 3 | 5 | 59 | $1,3 . 10^7$ |
| 7 | 10 | 50 | $2,5 . 10^7$ |
| 10 | 15 | 40 | $\geq 1,0 . 10^8$ |

BEISPIEL 4

| Substrat | - Silikatglas |
| Metallorganische Verbindung | - Zinntetramethyl |
| Organische monomere Verbindung | - Propen |
| Trägergas | - Argon |
| Elektrodentemperatur | - $100^{\circ}$ C |
| Heizung des Vorratsbehälters | - entfällt |
| Frequenz | - 13,56 MHz |
| Leistungsdichte | - 0,4 Watt/$cm^2$ |
| Druck im Reaktor | - 25 Pa |
| Reaktionsdauer | - 60 min für 2 $\mu$m Filmdicke |

Die Widerstandsmessungen an den Polymer-Zinnschichten ergeben folgende Werte :

TABELLE IV

| % Propen in Gasphase | Gasfluß sccm | Sn im Film Gewichts-% | Widerstand $\mu\Omega \cdot cm$ |
| --- | --- | --- | --- |
| 0 | 0 | 95 | 90 |
| 3 | 1 | 94 | 500 |
| 5 | 2 | 92 | 800 |
| 12 | 4 | 78 | $> 1,0 \cdot 10^8$ |

BEISPIEL 5

| Substrat | - Siliciumoxidkeramik |
| Metallorganische Verbindung | - Dicobaltoctacarbonyl |
| Organische monomere Verbindung | - Propen |
| Trägergas | - Argon/Wasserstoff |
| Elektrodentemperatur | - $80^{\circ}$ C |
| Heizung des Vorratsbehälters | - entfällt |
| Frequenz | - 13,56 MHz |
| Leistungsdichte | - 0,6 Watt/$cm^2$ |
| Druck im Reaktor | - 22,5 Pa |
| Reaktionsdauer | - 90 min für 0,5 $\mu$m Filmdicke |

Die erhaltennen Polymer-Cobalt-Schichten zeigten folgende Widerstandswerte :

TABELLE V

| % Propen in Gasphase | Gasfluß sccm | Co im Film Gewichts-% | Widerstand $\mu \Omega$ . cm |
|---|---|---|---|
| 1,5 | 1 | 78 | $2,5 . 10^3$ |
| 3,0 | 2 | 76 | $3,8 . 10^3$ |
| 4,4 | 3 | 72 | $5,2 . 10^3$ |
| 9,0 | 4 | 62 | $3,7 . 10^3$ |
| 13,0 | 6 | 43 | $> 1,0 . 10^8$ |

BEISPIEL 6

Dieses Beispiel betrifft die Herstellung von Polymer-Zinnschichten aus Tetramethylzinn(TMT) und Butan. Die Durchführung erfolgte wie im Beispiel 4 beschrieben
Die entsprechende Tabelle sieht dann wie folgt aus:

TABELLE VI

| % Butan in Gas-phase | Butanfluß sccm | Sn im Film Gewichts.-% | spez. Widerstand $\mu \Omega$cm |
|---|---|---|---|
| 0 | 0 | 95 | 90 |
| 5 | 2 | 91 | 2000-5000 |
| 10 | 4 | 82 | $(19-22) \times 10^4$ |
| 15 | 6 | 80 | $(65-97) \times 10^4$ |
| 20 | 8 | 70 | $(4-5) \times 10^6$ |

Ein unter gleichen Bedingungen erhaltener Butanfilm (ohne TMT-Dosierung) hat einen spez. Widerstand $1 \times 10^8$ μΩcm.

**Patentansprüche**

1. Verfahren zum Herstellen von elektrisch leitfähigen Polymer-Metallverbindungen auf anorganischen oder organischen Substraten, dadurch gekennzeichnet, daß das Substrat in einer Glimmentladungszone der Einwirkung von Allylcyclopentadienylpalladium-(II), Dimethylgold-(III)-acetylacetonat, Zinntetramethyl oder Dicobaltoctacarbonyl und Acrylnitril, Propen oder Butan ausgesetzt wird.
2. Verfahren nach Anspruch 1, dadurch gekennzeichnet, daß dem Allylcyclopentadienylpalladium-(II), Dimethylgold-(III)-acetylacetonat, Zinntetramethyl oder Dicobaltoctacarbonyl zusätzlich ein inertes Trägergas zugemischt wird, bevor die Plasmapolymerisation durchgeführt wird.
3. Verfahren nach Anspruch 1, dadurch gekennzeichnet, daß als Trägergas Argon, Helium oder Wasserstoff benutzt werden.
4. Verfahren nach Ansprüchen 1 und 4, dadurch gekennzeichnet, daß zur Herstelung eines bestimmten Widerstandswertes der Polymer-Metallverbindung das Verhältnis von Acrylnitril, Propen oder Butan zum Trägergas im Gasgemisch vorgewählt wird.

7

## Claims

1. Method for the production of electrically conductive polymer-metal compounds on inorganic or organic substrates, characterized in that the substrate is exposed to the effect of allyl-cyclopentadienyl-palladium-(II), dimethyl gold-(III)-acetylacetonate, tin tetramethyl or dicobalt-octacarbonyl and acrylonitrile, propene or butane in a glow discharge zone.

2. Method in accordance with Claim 1, characterized in that an inert carrier gas is added and mixed with the allylcyclopentadienyl-palladium-(II), dimethyl gold-(III)acetylacetonate, tin tetramethyl or dicobalt-octacarbonyl before the plasma polymerization reaction is carried out.

3. Method in accordance with Claim 1, characterized in that argon, helium or hydrogen are used as the carrier gas.

4. Method in accordance with Claims 1 to 4, characterized in that for production of a specific resistance value of the polymer-metal compound a specific ratio of acrylonitrile, propene or butane and the carrier gas in the gas mixture is preselected.

## Revendications

1. Procédé de fabrication de composés polymère-métal électriquement conducteurs sur des substrats inorganiques ou organiques, caractérisé en ce que le substrat, placé dans une zone de décharge d'effluves, est soumis à l'action d'allylcyclopentadienyl-palladium (II), d'acétylacétonate de diméthylor (III), de tétraméthyle d'étain ou de dicobaltoctacarbonyle et nitrile acrylique, propène ou butane.

2. Procédé suivant revendication 1, caractérisé en ce que l'on ajoute un gaz véhicule inerte à l'allylcyclopentadienyl-palladium (II), à l'acétylacétonate de diméthylor (III), au tétraméthyle d'étain ou au dicobaltoctacarbonyle pour former un mélange, avant d'effectuer la polymérisation au plasma.

3. Procédé suivant revendication 1, caractérisé en ce que l'on utilise comme gaz véhicule de l'argon, de l'hélium ou de l'hydrogène.

4. Procédé suivant revendications 1 et 4, caractérisé en ce que l'on présélectionne le rapport de nitrile acrylique, propène ou butane au gaz véhicule dans le mélange gazeux pour l'obtention d'une certaine valeur de résistance du composé polymère-métal.